# EUROPEAN PATENT APPLICATION

(11) **EP 4 383 224 A1**
(43) Date of publication of application: **12.06.2024**
(21) Application number: 22852586.1
(22) Date of filing: 25.03.2022
(51) Int. Cl.: G08C 19/02, H04B 3/54, G01F 1/00, G01F 1/84

(54) **SIGNAL PROCESSING DEVICE**

(30) Priority: 03.08.2021 JP 2021127259
(71) Applicant: Oval Corporation, Tokyo 161-8508 (JP)
(72) Inventor: WASHIO, Kenji, Tokyo 161-8508 (JP)
(74) Representative: KIPA AB
(86) International application number: PCT/JP2022/014223
(87) International publication number: WO 2023/013157

(57) **Abstract**

Provided is a signal processing device for a two-wire type sensor which ensures that two-wire cables can be used and an output of 4-20 mA is obtained, which are an advantage of a two-wire type configuration, while being capable of achieving high performance without sacrificing the performance. A signal processing device 300 including a sensor 10 and a signal converter 100 for converting a signal detected by the sensor, in which an external cable connection part 20 of the sensor is provided with a pair of output signal terminals 120, 130 for solid state pulses and a pair of power supply terminals 140, 150, one of the pair of output signal terminals is connected via a certain resistance 160 to a positive side of the power supply terminals, while the other of the pair of signal terminals and a negative side of the power supply terminals are short-circuited to each other in such a manner as to form superimposed power supply lines 210, 220 such that a current consumed by the power supply terminals of the sensor is superimposed with a current consumed by a pulse output circuit, the sensor and the signal converter are connected to each other using the superimposed power supply lines, and the signal converter extracts from a superimposed current wave flowing through the superimposed power supply lines only a signal 304 corresponding to a pulse output.

## Description

### Technical Field

The present invention relates to a signal processing device, and more particularly to a signal processing device for a two-wire type sensor.

### Background Art

Sensors are configured to provide a variety of outputs depending upon applications thereof. For example, a Coriolis flow meter detects an analog signal to detect the twist of a tube, and transmits this signal in the form of a current (see Patent Literature 1).

For a configuration to transmit a signal from a sensor, a "two-wire type sensor" in which only two electric wires serve for both power supply to a sensor and signal output from the sensor and a "sensor provided with a three or more electric wires" in which a power supply system and a signal system are separated from each other are typically employed. The "two-wire type sensor" is an already typical general-purpose technology for industrial applications and a commercial product for a flow meter as well as for a pressure transmitter, a temperature transmitter, etc. The "two-wire type configuration" is to control a current flowing through a power supply line for direct current power supply to a device, i.e., a current consumed by a device into a signal of 4-20 mA corresponding to an analog output for instrumentation depending upon a measured value of the device (see Patent Literature 2).

Meanwhile, the "sensor provided with a three or more electric wires" in which power supply to an electronic circuit of the sensor is separated from a signal line can have on the receiving side a simplified circuit, whereas, in comparison to the "two-wire type sensor", the number of steps for wiring (wiring cost) is increased, which is a problem.

### Prior Art Document

### Patent Literature

Patent Literature 1: JP4952820B2
Patent Literature 2: JP3139502B2

### Summary of Invention

### Technical Problem

A current naturally consumed by a device itself must be less than an analog output current and basically no more than 4 mA. Consequently, for the technology disclosed in Patent Literature 1, due to this design restriction, a device in which a two-wire type configuration can be implemented is restricted to a low-consumption measurement device basically capable of operating with a consumed current of 4 mA.

Further, even in the case where a two-wire type configuration can be implemented, for a flow meter which consumes a comparatively large current, such as a Coriolis flow meter disclosed in Patent Literature 1, a two-wire type configuration is implemented while a consumed current is restrained so that the performance tends to be sacrificed in comparison to a Coriolis flow mater not having a two-wire type configuration.

Moreover, in the case of the typical two-wire type configuration disclosed in Patent Literature 2, obtained signals are a signal of 4-20 mA which equals an instantaneous value so that there was also a problem that a flow meter does not allow real-time volume information to be obtained. However, as described above, a two-wire type sensor greatly reduces the number of steps for wiring in comparison to a three-wire type sensor or a sensor provided with more than three wires, whereby total cost for the entirety of a device can be reduced and an early set-up for a device can be achieved.

A flow meter may be of a mechanical type (a gear type or a turbine type) known for a long time which requires no external power supply and have a contact pulse output such that only a pulse signal corresponding to a volume can be transmitted through two-wire cables. This two-wire type (mechanical type) flow meter can obtain real-time volume information, while restricted to being of a mechanical type which requires no external power supply so that there was also a problem that a latest electronic type flow meter which is multifunctional, easy to use, and basically maintenance-free cannot be substituted therefor.

The present invention has been made in view of these actual situations and it is an object of the present invention to provide a signal processing device for a two-wire type sensor which ensures that two-wire cables can be used (for both power delivery and signal transmission, which restrains cost) and an output of 4-20 mA is obtained (a signal for instrumentation for various purposes can be obtained), which are an advantage of a two-wire type configuration, while being capable of achieving high performance without sacrificing the performance.

### Solution to Problem

To solve the above problems, a first technical means according to the present invention is a signal processing device including a sensor and a signal converter for converting a signal detected by the sensor, characterized in that an external cable connection part of the sensor is provided with a pair of output signal terminals for solid state pulses and a pair of power supply terminals, one of the pair of output signal terminals is connected via a certain resistance to a positive side of the power supply terminals, while the other of the pair of signal terminals and a negative side (0V) of the power supply terminals are short-circuited to each other in such a manner as to form superimposed power supply lines such that a current consumed by the power supply terminals of the sensor is superimposed with a current consumed by a pulse output circuit, the sensor and the signal converter are connected to each other using the superimposed power supply lines, and the signal converter extracts from a superimposed current wave flowing through the superimposed power supply lines only a signal corresponding to a pulse output.

To solve the above problems, a second technical means according to the present invention is characterized in that the signal converter is provided with a certain current detecting resistance and a frequency filter or a comparator, or both the frequency filter and the comparator, and extracts from a superimposed current wave flowing through the superimposed power supply lines only a signal corresponding to a pulse output.

To solve the above problems, a third technical means according to the present invention is characterized by further comprising a pulse signal extracting filter for extracting from the superimposed current waveform only a pulse signal using the current detecting resistance, the frequency filter or the comparator, or both the frequency filter and the comparator.

To solve the above problems, a fourth technical means according to the present invention is characterized by further comprising a frequency/current converter for converting a pulse signal obtained by the pulse signal extracting filter to a certain current signal.

To solve the above problems, a fifth technical means according to the present invention is characterized in that the sensor is a three-wire type or four-wire type flow meter.

To solve the above problems, a sixth technical means according to the present invention is characterized in that, on the basis of a number of pulses and frequency information of a pulse signal obtained by the pulse signal extracting filter, a volume and a flow rate are calculated, and a display provided in advance indicates a volume and a flow rate or an abnormality alarm depending upon a volume/flow rate state.

To solve the above problems, a seventh technical means according to the present invention is characterized in that an alarm output is transmitted when a frequency of a pulse signal obtained by the pulse signal extracting filter exceeds or falls below a predetermined frequency threshold.

### Effects of Invention

According to the present invention, in a three-wire type or four-wire type sensor which is of high performances and has an open collector pulse output, the positive line of the power supply and the positive part of the open collector are connected to each other via a certain resistance, and thus, on the power supply line, a natural consumed current, which does not sharply change, of the flow meter is superimposed with a consumed current of pulse (a pulse signal of approximately 1 Hz to a few kHz) of the open collector. Then, in the signal converter which serves as an interface with a host device, a certain frequency filter can extract from a consumed current waveform only a pulse signal. Further, a frequency/current (F/I) conversion of the pulse signal can be made to carry out an output of 4-20 mA and also a pulse output.

In addition, the present invention can provide an already-installed instrumentation system provided with a two-wire type flow meter, such as a variable area flow meter and a differential pressure flow meter, which utilizes an advantage of a sensor provided with a three or more electric wires and restrains wiring cost. In other words, employing the signal processing device according to the present invention enables updating only a flow meter to a high performance Coriolis flow mater not having a two-wire type configuration without changing already-installed two-wire cables and an already-installed host receiving device.

For example, it was conventionally impossible to substitute a two-wire type flow meter which is of a mechanical type requiring no external power supply and has a contact pulse output (corresponding to a volume) function with a Coriolis flow meter requiring an external power supply. In contrast, the signal processing device according to the present invention obtains also a pulse output and thereby enables updating only a flow meter to a high performance Coriolis flow mater not having a two-wire type configuration without changing already-installed two-wire cables and an already-installed host receiving device.

Thus, the present invention can provide a signal processing device for a two-wire type sensor which ensures that two-wire cables can be used (for both power delivery and signal transmission, which can restrain cost) and an output of 4-20 mA is obtained (a signal for instrumentation for various purposes can be obtained), which are an advantage of a two-wire type configuration, while being capable of achieving high performance without sacrificing the performance.

### Brief Description of Drawings

Fig. 1 is a block diagram illustrating a configuration in which superimposing processing is performed on a power supply to carry out signal transmission according to an embodiment of the present invention.
Fig. 2 is a block diagram illustrating a configuration to carry out signal transmission of a three-wire type sensor according to a conventional technology.
Fig. 3 is a block diagram illustrating an entire configuration of a signal processing device including a sensor/power supply/signal conversion according to an embodiment of the present invention.
Fig. 4 is diagram illustrating a (first) example of substitution of an already-installed two-wire type sensor according to an embodiment of the present invention.
Fig. 5 is a diagram illustrating a (second) example of substitution of an already-installed two-wire type sensor according to an embodiment of the present invention.

### Description of Embodiments

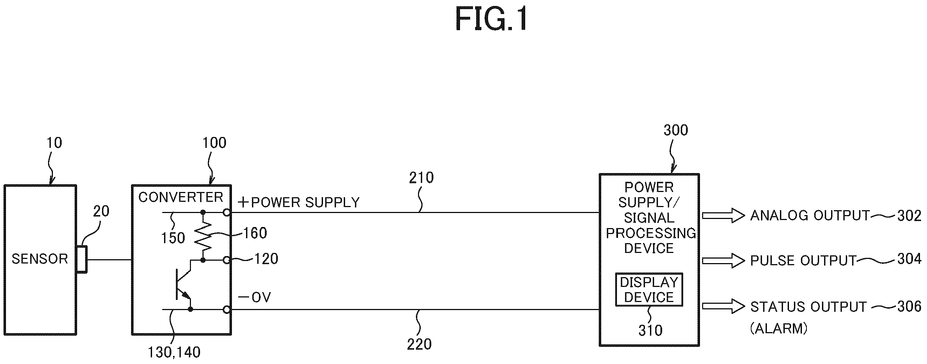

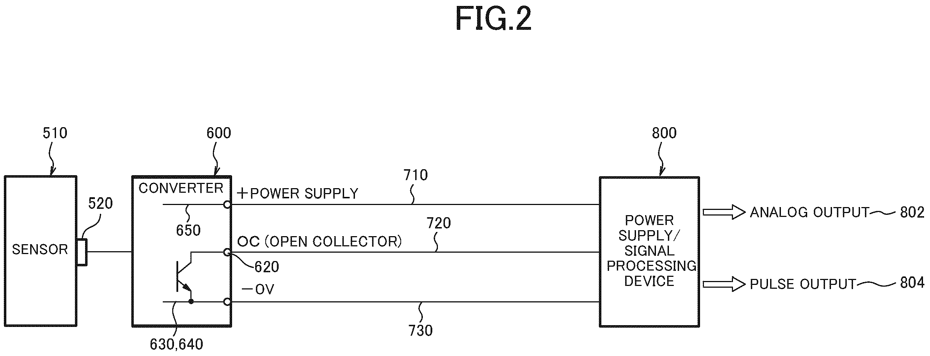

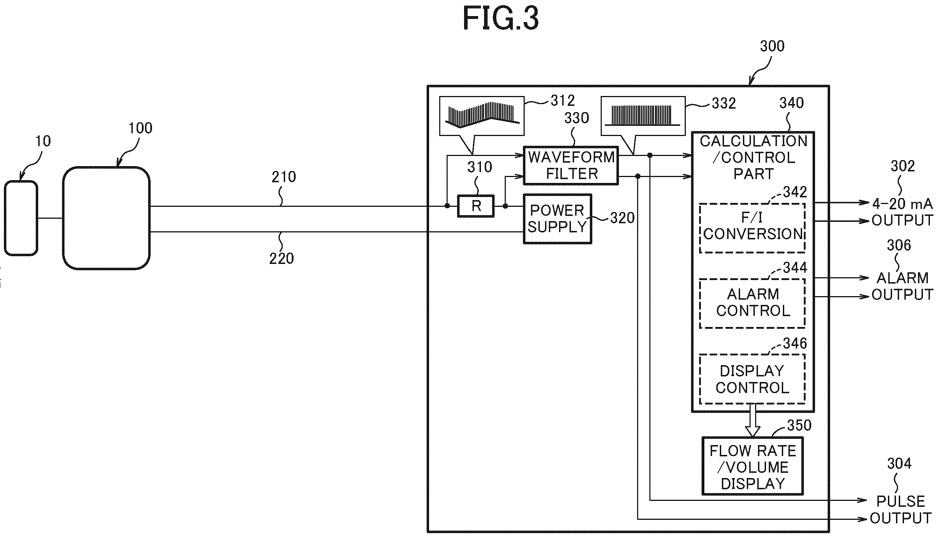

Hereinafter, preferable embodiments of a signal processing device according to the present invention will be described with reference to the accompanying drawings. Fig. 1 is a block diagram illustrating a configuration in which superimposing processing is performed on a power supply to carry out signal transmission according to an embodiment of the present invention. Fig. 2 is a block diagram illustrating a configuration to carry out signal transmission of a three-wire type sensor according to a conventional technology. Fig. 3 is a block diagram illustrating an entire configuration of a signal processing device including a sensor/power supply/signal conversion according to an embodiment of the present invention.

First of all, in a circuit of a conventional two-wire type sensor, a signal line is shared with a power supply to drive the two-wire type sensor so that, in contrast to a case using a contact ON/OFF signal which is the most simple and easy to handle as a signal, a circuit drive current flows even under an OFF state in which normally a current is not to flow.

Further, it was necessary to secure such a residual voltage as to allow for circuit drive even under an ON state in which desirably the resistance and residual voltage are zero. In other words, there occur various restrictions on a load connected to the sensor or a connection of a plurality of sensors, such as a connection in series and a parallel connection.

In addition, there also occurs a restriction that a naturally consumed current of a sensor must be no more than a control current (usually no more than 4 mA), and consequently a two-wire type configuration cannot be implemented for a sensor which consumes a large current, or a consumed current must be reduced so that the performance tends to be sacrificed.

Next, in a three-wire type configuration according to a conventional technology as illustrated in Fig. 2, a signal line is usually configured to be an open collector, which thus also allows for a power supply different than a sensor power supply, so that, in contrast to a case using a conventional two-wire type configuration, restrictions can be reduced. However, as illustrated in Fig. 2, wiring using three-wire cables is necessary and the number of steps for wiring is accordingly increased.

For an output from the sensor, in a manner similar to the three-wire type configuration in Fig. 2, a circuit according to an embodiment of the present invention in Fig. 1 is provided with a pair of signal terminals 620, 630 for solid state pulses and a pair of power supply terminals 640, 650 from the external cable connection 520 of the sensor 510, which will be explained later in detail. Note that the terminals may be configured using a mechanical contact or an open collector. Further note that, in Fig. 2, an external cable connection part 610 is schematically illustrated, while specifically including the above terminals which are connected to respective electric wires each denoted with a reference sign in a converter 600.

Thus, through an external cable connection part 520, an output from the sensor 510 is transmitted to the converter 600. In the three-wire type configuration according to a conventional technology in Fig. 2, from the converter 600, a signal line 620 of the open collector is an independent cable.

The converter 600 and the power supply/signal processing device 800 are connected to each other using power supply lines 710, 730 and an open collector 720. After receiving signals, the power supply/signal processing device 800 carries out compositing processing of these signals, for example, into an analog output 802 and a pulse output 804.

Meanwhile, in a converter 100 in Fig. 1 according to an embodiment of the present invention, an output signal terminal 120 which is one of the pair of output signal terminals and is an open collector is connected via a certain resistance 160 to a positive side power supply terminal 150. Further, the other signal terminal 130 and a negative 0 side power supply terminal 140 are short-circuited to each other.

Using such a circuit configuration, the cables 210, 220 connected respectively to the pair of power supply terminals 140, 150 are configured to be superimposed power supply lines 210, 220, respectively, such that a current consumed by the power supply terminals of the sensor is superimposed with a current consumed by a pulse output circuit.

The converter 100 and the power supply/signal processing device 300 are connected to each other using the two superimposed power supply lines 210, 220. After receiving signals, the power supply/signal processing device 300 carries out processing of these signals into an analog output 302, a pulse output 304, etc.

Next, the power supply/signal processing device 300 will be described in detail also with reference to Fig. 3. A signal outputted from a sensor 10 is transmitted via an external cable connection part 20 and the converter 100 through the superimposed power supply lines 210, 220 to the power supply/signal processing device 300.

The power supply/signal processing device 300 may be configured in such a manner as to be provided with a certain current detecting resistance 310 and a frequency filter or a comparator or both the frequency filter and the comparator. In an embodiment illustrated in Fig. 3, a waveform filter 330 may represent either a frequency filter or a comparator or both the frequency filter and the comparator. Further, the superimposed power supply lines 210, 220 are connected to a power supply 320 for supplying power for the sensor.

A waveform is filtered, as appropriate, by the waveform filter 330, for example, in such a manner as to be indicated, for example, by a waveform 312 before the waveform filter 330 and by a waveform 332 after the waveform filter 330.

An output of the waveform filter 330 is transmitted to a calculation/control part 340 or maintained as a pulse output 304. The pulse output 304 may be output to a host device of a measurement system, so as to carry out various processing and analyses.

The calculation/control part 340 in the present embodiment may carry out, for example, a frequency/current (F/I) conversion 342 to output a current output 302 of 4-20 mA, an alarm control 344 to output an alarm output 306, such as alert information of the sensor 10, and a display control 346 to indicate a flow rate/volume using a flow rate/volume display 350.

In other words, according to this configuration, from a superimposed current wave flowing through the superimposed power supply lines, only a signal corresponding to a pulse output can be extracted and thereby converted to a variety of outputs.

Thus, according to an embodiment of the present invention, a configuration of a three-wire type or four-wire type sensor which is of high performances and has an open collector pulse output is maintained, while the positive (+) line of the power supply and the positive (+) part of the open collector are connected to each other via a certain resistance.

Consequently, a consumed current which does not sharply change is superimposed with a consumed current of pulse of the open collector. Then, the power supply/signal processing device 300 is provided with the frequency filter and the comparator, thereby extracting from a consumed current waveform only a pulse signal. Further, a frequency/current (F/I) conversion of the pulse signal can be made to carry out an output of 4-20 mA and also a pulse output.

The present invention can provide a signal processing device for a two-wire type sensor which ensures that two-wire cables can be used (for both power delivery and signal transmission, which restrains cost) and an output of 4-20 mA is obtained (a signal for instrumentation for various purposes can be obtained), which are an advantage of a two-wire type configuration, while being capable of achieving high performance without sacrificing the performance.

In the case of a two-wire type sensor having a typical output of 4-20 mA, the sensor is driven using 20 mA or less, while, for a current to be used to drive the sensor (including calculation and control), 4 mA or less is used for processing. In this regard, according to an embodiment of the present invention, a two-wire transmission system can be configured using a sensor of high performance and for various purposes in which a drive current exceeds 4 mA and typically a two-wire type configuration cannot be employed.

For example, in the case of a high-performance Coriolis flow meter which is one of sensors provided with three or more electric wires may have a nominal consumed current of approximately 400 mA. In order that this high-performance Coriolis flow meter having a large nominal consumed current is matched with a conventional two-wire type configuration, in other words, this sensor is driven using 4 mA, it is necessary that a configuration has energy consumption reduced to approximately 1/10. Typical measures for reducing a consumed current include lowering the resolution for digital processing (lowering the precision), decreasing the calculation frequency (deteriorate the responsiveness), and the like, which basically result in lowering the performance. In contrast, the present invention allows a conventional high performance Coriolis flow meter (for sale still now) provided with three or more electric wires to be employed for a two-wire system without deteriorating the performance.

Further, typically in an analog meter, such as a Coriolis flow meter, a consumed current during a normal operation changes gently and no sharp change occurs. Accordingly, using a frequency filter and separating and restoring a pulse signal in the present invention can be realized comparatively easily using ordinary technology. Thus, in the present invention, it is not likely that, even after a once superimposed signal is separated and composited, the quality of a composited signal deteriorates.

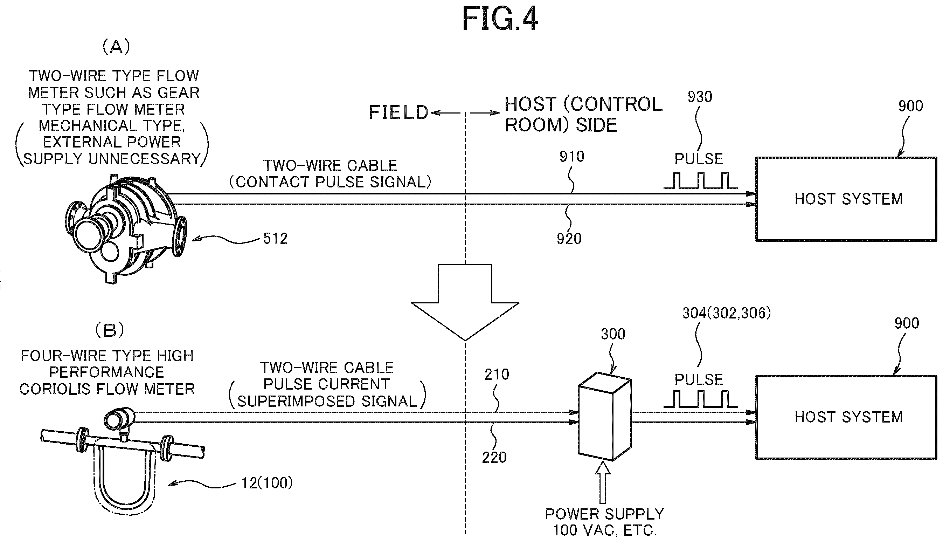

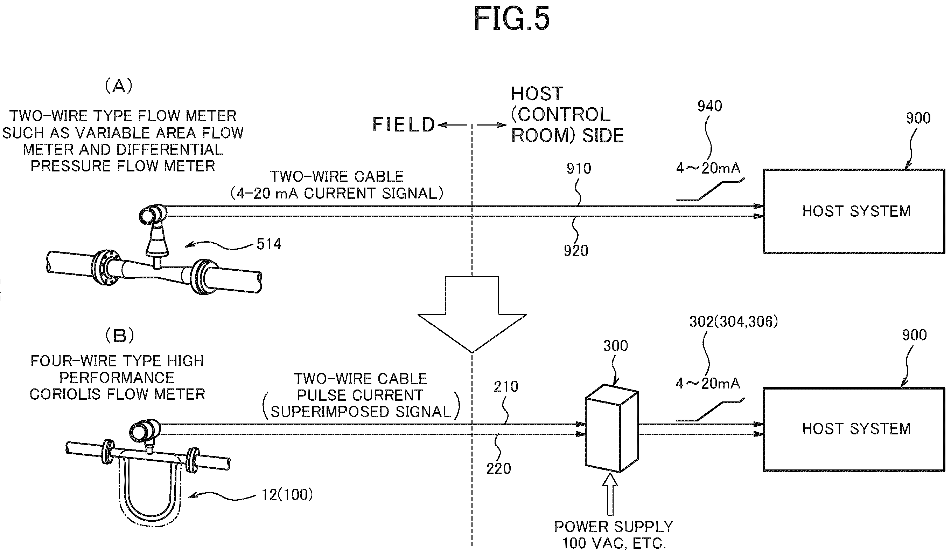

Next, examples of substitution of a sensor provided with three or more electric wires by applying the present invention when a two-wire type sensor is already installed will be described with reference to Fig. 4 and 5.

With reference to Fig. 4, even when a two-wire type flow meter 512, such as a gear type flow meter, is already installed as illustrated in Fig. 4(A), substitution of a four-wire type high performance Coriolis flow meter 12 can be easily made as illustrated in Fig. 4(B).

Fig. 4(A) illustrates a conventional typical configuration in which a pulse signal 930 is output from the two-wire type flow meter 512, such as a gear type flow meter, through two-wire cables 910, 920 to a host system 900. On the other hand, in Fig. 4(B), a high-performance Coriolis flow meter 12 provided with an unillustrated converter 100 substitutes for the two-wire type flow meter 512. Further, the two-wire cables 910, 920 in Fig. 4(A) are used as the superimposed power supply lines 210, 220.

A signal (power supply) from the superimposed power supply lines 210, 220 is transmitted to the power supply/signal processing device 300 according to the present embodiment. The power supply/signal processing device 300 carries out a conversion to the pulse output 304 (a current output 302, an alarm output 306, and the like are also possible) and an output to the host system 900 already installed. Thus, substitution of the high-performance Coriolis flow meter 12 can be made while the two-wire cables 910, 920 (the superimposed power supply lines 210, 220) and the host system 900 which are already installed are maintained.

Next, Fig. 5(A) illustrates a conventional typical configuration in which a current signal 940 of 4-20 mA is outputted from the two-wire type flow meter 514, such as a variable area flow meter and a differential pressure flow meter, through the two-wire cables 910, 920 to the host system 900. On the other hand, in Fig. 5(B), the high-performance Coriolis flow meter 12 provided with the unillustrated converter 100 substitutes for the two-wire type flow meter 514. Further, the two-wire cables 910, 920 in Fig. 5(A) are used as the superimposed power supply lines 210, 220.

A signal (power supply) from the superimposed power supply lines 210, 220 is transmitted to the power supply/signal processing device 300 according to the present embodiment. The power supply/signal processing device 300 carries out a conversion to the pulse output 304 (a current output 302, an alarm output 306, and the like are also possible) and an output to the host system 900 already installed. Thus, substitution of the high-performance Coriolis flow meter 12 can be made while the two-wire cables 910, 920 (the superimposed power supply lines 210, 220) and the host system 900 which are already installed are maintained.

Thus, the present invention is to solve the problem of conventional two-wire type transmission (an output of 4-20 mA and a pulse output equal one-way signal transmission from a sensor to a host side). In other words, using wiring already installed, the present invention can provide a signal processing device for a two-wire type sensor which ensures that two-wire cables can be used (for both power delivery and signal transmission, which restrains cost) and an output of 4-20 mA is obtained (a signal for instrumentation for various purposes can be obtained), which are an advantage of a two-wire type configuration, while being capable of achieving high performance without sacrificing the performance.

According to the present invention, an open collector pulse signal outputted from a sensor is converted to a current signal which is superimposed on power supply lines, thereby carrying out information transmission in a two-wire manner, while the transmitted signal is restored by the power supply/signal processing device 300 to a signal for instrumentation for various purposes (a current signal of 4-20 mA or a pulse signal), which enables acquisition of information using wiring already installed for a host device for various purposes, such as a PLC. Note that several embodiments according to the present invention were explained but the present invention is not to be restricted thereto.

### Reference Signs List

- 10, 12, 510, 512, 514: sensor
- 20, 520: external cable connection part
- 100, 600: converter
- 120, 130, 620, 630: output signal terminal
- 140, 150, 640, 650: power supply terminal
- 160: resistance
- 210, 220: superimposed power supply line
- 300, 800: power supply/signal processing device
- 302, 802: analog output
- 304, 804, 930: pulse output
- 306 alarm: output
- 312, 332: waveform
- 310 current: detecting resistance
- 320: power supply
- 330: waveform filter
- 340: calculation/control part
- 342: frequency/current (F/I) conversion
- 344: alarm control
- 346: display control
- 350: flow rate/volume display
- 710, 730: power supply line
- 720: open collector
- 900: host system
- 910, 920: two-wire cable

## Claims

1. A signal processing device including a sensor and a signal converter for converting a signal detected by the sensor, **characterized in that**
an external cable connection part of the sensor is provided with a pair of output signal terminals for solid state pulses and a pair of power supply terminals,
one of the pair of output signal terminals is connected via a certain resistance to a positive side of the power supply terminals, while the other of the pair of signal terminals and a negative side of the power supply terminals are short-circuited to each other in such a manner as to form superimposed power supply lines such that a current consumed by the power supply terminals of the sensor is superimposed with a current consumed by a pulse output circuit,
the sensor and the signal converter are connected to each other using the superimposed power supply lines, and
the signal converter extracts from a superimposed current wave flowing through the superimposed power supply lines only a signal corresponding to a pulse output.

2. The signal processing device according to claim 1, **characterized in that** the signal converter is provided with a certain current detecting resistance and a frequency filter or a comparator, or both the frequency filter and the comparator, and extracts from a superimposed current wave flowing through the superimposed power supply lines only a signal corresponding to a pulse output.

3. The signal processing device according to claim 2, **characterized by** further comprising a pulse signal extracting filter for extracting from the superimposed current waveform only a pulse signal using the current detecting resistance, the frequency filter or the comparator, or both the frequency filter and the comparator.

4. The signal processing device according to claim 2 or 3, **characterized by** further comprising a frequency/current converter for converting a pulse signal obtained by the pulse signal extracting filter to a certain current signal.

5. The signal processing device according to any one of claims 1-4, **characterized in that** the sensor is a three-wire type or four-wire type flow meter.

6. The signal processing device according to claim 1 or 2, **characterized in that**, on the basis of a number of pulses and frequency information of a pulse signal obtained by the pulse signal extracting filter, a volume and a flow rate are calculated, and a display provided in advance indicates a volume and a flow rate or an abnormality alarm depending upon a volume/flow rate state.

7. The signal processing device according to claim 1 or 2, **characterized in that** an alarm output is transmitted when a frequency of a pulse signal obtained by the pulse signal extracting filter exceeds or falls below a predetermined frequency threshold.
